Europäisches Patentamt

European Patent Office

Office européen des brevets

(19)

(11) Veröffentlichungsnummer: **0 203 215**
**B1**

(12) # EUROPÄISCHE PATENTSCHRIFT

(45) Veröffentlichungstag der Patentschrift:
21.02.90

(51) Int. Cl.⁵: **G 03 F 1/00, G 03 B 41/00**

(21) Anmeldenummer: 85106609.2

(22) Anmeldetag: 29.05.85

(54) **Verfahren zur Reparatur von Transmissionsmasken.**

(43) Veröffentlichungstag der Anmeldung:
03.12.86 Patentblatt 86/49

(45) Bekanntmachung des Hinweises auf die Patenterteilung:
21.02.90 Patentblatt 90/8

(84) Benannte Vertragsstaaten:
DE FR GB

(56) Entgegenhaltungen:
EP-A- 0 036 310
EP-A- 0 094 501
DE-A- 2 702 934
US-A- 3 748 975

PATENTS ABSTRACTS OF JAPAN, Band 7, Nr. 216
(P-225) [1361], 24. September 1983; & JP - A - 58 111 038
(MATSUSHITA DENSHI KOGYO K.K.) 01-07-1983
IBM TECHNICAL DISCLOSURE BULLETIN, Band 16, Nr.
2, Juli 1983, Seite 572, New York, US; W.M. MORGAN:
"Microscope exposure of photoresists"
IBM TECHNICAL DISCLOSURE BULLETIN, Band 27, Nr.
8, Januar 1985, Seiten 4815,4816, New York, US; U.
BEHRINGER et al.: "Method of producing defect-free
transmission masks"
PATENTS ABSTRACTS OF JAPAN, Band 7, Nr. 146
(P-206) [1291], 25. Juni 1983; & JP - A - 58 58 548 (TOKYO
SHIBAURA DENKI K.K.) 07-04-1983
JEE JOURNAL OF ELECTRONIC ENGINEERING, Band

(73) Patentinhaber: IBM DEUTSCHLAND GMBH,
Pascalstrasse 100, D-7000 Stuttgart 80 (DE)

(84) Benannte Vertragsstaaten: DE

(73) Patentinhaber: International Business Machines
Corporation, Old Orchard Road, Armonk,
N.Y. 10504 (US)

(84) Benannte Vertragsstaaten: FR GB

(72) Erfinder: Behringer, Uwe, Dr., Auf den Beeten 5,
D-7403 Ammerbuch 4 (DE)
Erfinder: Vettinger, Peter, Langmoosstrasse 33,
CH-8135 Langnau/am Albis (CH)
Erfinder: Dätwyler, Kurt, Reidholzstrasse 58,
CH-8805 Richterswil (CH)

(74) Vertreter: Kreidler, Eva-Maria, Dr. rer. nat., Schönaicher
Strasse 220, D-7030 Böblingen (DE)

(56) Entgegenhaltungen: (Fortsetzung)
19, Nr. 192, Dezember 1982, Seiten 65-67, Tokyo, JP; D.
AWAMURA: "Automatic photomask and wafer fault
inspection systems"

## Beschreibung

Die Erfindung betrifft ein Verfahren zum Reparieren von Transmissionsmasken für die Röntgenstrahl-, Elektronenstrahl- bzw. Ionenstrahllithographie, bei dem die gespeicherten Daten der Maskenstruktur mit den Ortskoordinaten unerwünschter Maskenlöcher verglichen werden.

Der in der VLSI-Halbleitertechnologie anhaltende Trend zur Reduzierung der Schaltkreisdimensionen macht Lithographieverfahren und Belichtungssysteme erforderlich, die das Drucken von Mustern mit Dimensionen im Submikrometerbereich gestatten. Mit den bisher verwendeten lichtoptischen Belichtungssystemem können diese Muster mit den gewünschten Submikrometerdimensionen wegen der geringen Fokussierungstiefe und der Streuung des Lichts an den Kanten der Masken nicht mehr hergestellt werden. Es ist deshalb erforderlich, zu Verfahren überzugehen, bei denen nichtoptische Strahlungsarten mit viel kürzeren Wellenlängen als die in lichtoptischen Systemen eingesetzten verwendet werden. Als nichtoptische Strahlung werden derzeit Röntgenstrahlen, Elektronenstrahlen oder Ionenstrahlen eingesetzt.

Für die Belichtung mit Röntgenstrahlen, Elektronen- oder Ionenstrahlen müssen Transmissionsmasken mit Submikrometerstrukturen und einer hohen geometrischen Präzision, die für das Übereinanderdrucken erforderlich ist, hergestellt werden. Die Masken für Elektronen- und Ionenstrahllithographie sind, im Gegensatz zu Masken für die optische Belichtung, die aus Chromstrukturen auf Glassubstraten aufgebaut sind, aus dünnen Folien oder Membranen aus Silicium oder Siliciumnitrid aufgebaut und weisen in den transparenten Bereichen physikalische Löcher für den Durchlaß der Strahlung auf. Ihre Herstellung erfolgt in photolithographischen Prozessen, gefolgt von isotropen und streng anisotropen Ätzprozessen. Während des Herstellungsprozesses kann es dazu kommen, daß durch Staubteilchen oder noch viel häufiger durch eine Lochbildung in dem zu belichtenden Photoresist zusätzliche, unerwünschte Löcher auftreten. Außerdem können durch Gitterfehler, die während der Bordotierung der Wafer, aus denen die Masken hergestellt werden, auftreten, beim selektiven Ätzprozeß zusätzliche Defektlöcher entstehen. Diese Defektlöcher sind unerwünscht, weil sie während des Herstellungsprozesses für die Transmissionsmaske wie die gewünschten Strukturen eingeätzt werden und damit die Maskenstrukturen verfälschen. Selbst bei besten Reinraumbedingungen kann das Auftreten dieser zusätzlichen Löcher nie ganz verhindert werden. Deshalb wurden Verfahren entwickelt, um Transmissionsmasken zu reparieren.

DE-A-2 702 934 betrifft ein Verfahren und eine Vorrichtung zur automatischen Prüfung und Korrektur von Photomasken, bei dem wenigstens 2 Masken gleichen Musters hergestellt werden, die Muster der jeweiligen Masken in elektrische Signale und diese wiederum auf der Basis wenigstens eines Bezugswerts in Binärsignale umgewandelt werden, die Binärsignale verglichen werden und das Vorhandensein eines Defekts in den Masken durch Übereinstimmung und Nichtübereinstimmung der Binärsignale festgestellt wird. Die Ergebnisse dieser Feststellung werden in einer Speichereinrichtung gespeichert und können im Verfahren der Korrektur der defekten Bereiche der Maske ausgelesen werden. Mit dieser Information wird im XY-Tisch, auf dem sich die defekte mit Photoresist beschichtete Maske in der Weise gesteuert, daß der defekte Bereich genau unter die Objektivlinse gelangt. Dieselbe Information steuert einen Schlitzantriebsmotor und bestimmt entsprechend der Größe des defekten Bereichs die Schlitzbreite. Nach Belichtung des Photoresistfilms auf den defekten Bereichen der Masken werden diese Bereiche entfernt und Chrom unter Verwendung der strukturierten Photoresistschicht als Maske auf das Glassubstrat aufgedampft. Danach wird die Photoresistschicht entfernt.

EP-A-0 094 501 betrifft ein Verfahren zur Inspektion von Maskenmustern, bei dem von der Maske eine Komplementärmaske erzeugt wird mit erhabenen, undurchsichtigen Bereichen im Bereich der Löcher der ursprünglichen Maske. Diese Komplementärmaske wird mit einem Elektronenstrahl, welcher durch die Schreibdaten der Maske kontrolliert wird, abgetastet zur Feststellung von Koinzidenzen und Nicht-Koinzidenzen zwischen dem Schreibstrahl und dem Muster der Komplementärmaske.

Ein in der lichtoptischen Lithographie verwendetes Maskenreparaturverfahren, bei dem mit Hilfe eines Laserstrahls der Chromüberschuß von Maskenstrukturen weggenommen wird bzw. Defektlöcher durch Aufpinseln von Photoresist per Hand geschlossen werden, kann zur Reparatur von Transmissionsmasken nicht verwendet werden, weil die Reparatur, nicht wie bei lichtoptischen Masken, an Vorlagen mit zehnfacher Vergrößerung, sondern an den Transmissionsmasken selbst mit Strukturen im Maßstab 1:1 vorgenommen wird, wobei die Strukturen oft kleiner als 0,5 μm ausfallen.

In IBM Technical Disclosure Bulletin, Vol. 27, No. 8, Jan. 1985, S. 4815-4816 ist ein Verfahren zur Reparatur fehlerhafter Transmissionsmasken beschrieben, bei dem auf die Oberseite der fehlerhaften Maske eine Photoresistschicht aufgetragen und alle Maskenlöcher, einschließlich der fehlerhaften, geschlossen werden. Anschließend wird die Photoresistschicht durch eine Transmissionsmaske, deren Struktur identisch mit der Struktur der zu reparierenden Maske ist, belichtet. Hierbei muß darauf geachtet werden, daß in der zur Belichtung verwendeten Maske etwa vorhandene Defektlöcher nicht an denselben Stellen wie bei der zu reparierenden Maske auftreten. Weitere Fehler, die durch Defektstellen in der zur Reparatur verwendeten Maske bedingt sind, können in der Weise ausgeschaltet werden, daß die Photoresistschicht auf der zu reparierenden Maske noch einmal durch eine strukturgleiche Maske belichtet wird, wobei wiederum die Defektlöcher dieser Maske nicht mit den Defektlöchern in der zuvor benutzten Maske und der zu reparierenden Maske zusammenfallen dürfen. Dieses Verfahren hat den Nachteil, daß der auf der zu reparierenden Maske verbleibende Photoresist bei der späteren Belichtung der Maske zu Aufladungen führen kann, was unerwünscht ist. Außerdem ist die Anwendung dieses Reparaturverfahrens nur dann sinnvoll, wenn eine Inspektion der zu reparierenden Maske ergibt, daß viele Defektlöcher zu schließen sind. Wenn, als Folge sehr guter Reinraumbedingungen, eine visuelle Inspektion der Maske ergibt, daß nur wenige Defektlöcher zu schließen sind, ist ein Verfahren vorteilhaft, mit dem einzelne Defektlöcher repariert werden können.

Bei einem solchen Verfahren wird beispielsweise in einem Vakuumsystem ein fein fokussierter Elektronenstrahl zeilenweise über eine unerwünschte Maskenöffnung oder am Rand einer Maskenöffnung entlanggeführt, um die Öffnung durch die dem Strahl folgenden Kontaminationsstreifen vollständig zu verschließen, oder um die Form der Maskenöffnung zu korrigieren. Unter der Einwirkung des Elektronenstrahls erfolgt eine Polymerisation von Monomermolekülen, die aus dem Diffusionspumpenöl stammen oder im Bereich der Maske zudosiert werden. Das Polymergerüst kann nach dem Auffüllen der unerwünschten Maskenöffnung mit einem leitenden Material von der Rückseite der Maske her wieder entfernt werden. Anschließend wird eine Goldschicht auf die Vorder- und Rückseite der Maske aufgebracht. Nachteilig an diesem Verfahren ist, daß die Reparatur eines einzelnen Loches mehrere Minuten in Anspruch nimmt und damit der Zeitaufwand für die Reparatur der Maske wirtschaftlich nicht mehr vertretbar ist.

Aufgabe der Erfindung ist daher, ein Verfahren zur Reparatur von Transmissionsmaken anzugeben, mit dem alle Muster der Maske, d.h. alle Löcher in einem wirtschaftlich vertretbaren Zeitaufwand auf ihre Sollmaße gebracht werden können.

Die Aufgabe der Erfindung wird gelöst durch ein Verfahren gemäß Patentanspruch 1.

Vorteilhafte Ausführungsformen der Erfindung sind in den Unteransprüchen niedergelegt.

Die Erfindung wird anhand der speziellen Beschreibung und der Figuren 1 bis 5 näher erläutert.

Es stellen dar:

Fig. 1 einen Querschnitt durch eine Elektronenstrahl-Transmissionsmaske;

Fig. 2A eine Transmissionsmaske mit physikalischen Löchern;

Fig. 2B dieselbe Maske mit je zwei Stegen aus vernetztem Photoresist;

Fig. 3A eine Transmissionsmaske, bei der alle Löcher des Musters geöffnet sind;

Fig. 3B dieselbe Maske, ganzflächig mit Photoresist bedeckt;

Fig. 3C dieselbe Maske, in der ein fehlerhaftes, zu reparierendes Loch geöffnet ist;

Fig. 3D das fehlerhafte Loch aus Fig. 3C in Vergrößerung;

Fig. 4A eine Transmissionsmaske mit einem Defektloch außerhalb des eigentlichen Maskenmusters;

Fig. 4B dieselbe Maske, ganzflächig mit Photoresist bedeckt;

Fig. 4C dieselbe Maske nach der Entfernung des Photoresists, mit selbsttragender Goldschicht im Bereich der Löcher;

Fig. 5A ein Ausschnitt aus einer Transmissionsmaske mit einem Defektloch;

Fig. 5B das Defektloch aus Fig. 5A, welches mit einer Goldschicht verschlossen ist.

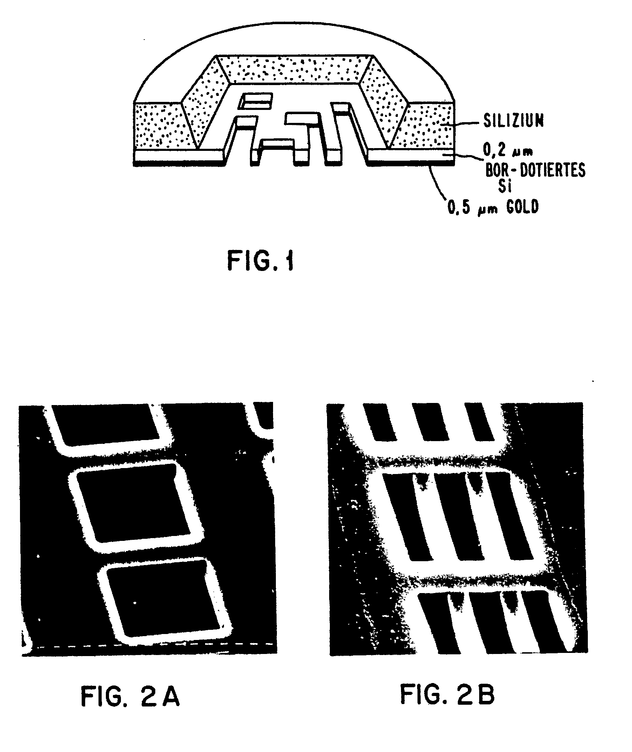

Die in Fig. 1 gezeigte Elektronenstrahl-Transmissionsmaske besteht aus einer einkristallinen bordotierten Siliciummembran von etwa 2 bis 3 µm Dicke und einer Goldschicht auf ihrer Oberfläche, welche die strahlstoppenden Eigenschaften verbessert. Die Maske besitzt die Größe eines Siliciumwafers und enthält als feinste Strukturen Strukturen von etwa 1/4 µm Breite. Der gleiche Maskentyp kann auch für die Ionenstrahl- oder Röntgenstrahllithographie verwendet werden.

Nachfolgend wird kurz ein Verfahren zur Herstellung einer Maske für die Elektronenstrahl-, Ionenstrahl- oder Röntgenstrahllithographie beschrieben. Als Maskensubstrat wird ein etwa 0,2 bis 0,4 mm dicker Siliciumwafer mit einer 100-Orientierung, der auf beiden Seiten poliert ist, verwendet. Die Rückseite des Wafers wird mit einer etwa 0,5 bis 1 µm dicken Siliciumdioxidschicht bedeckt. Von der Vorderseite des Siliciumwafers wird Bor in das Substrat eindiffundiert bis zu einer Oberflächenkonzentration von wenigstens $10^{20}$ Boratomen/$cm^3$. Die Bordiffusion dient als Ätzbarriere bei einem späteren Ätzen des Siliciumwafers und bestimmt dadurch die Maskendicke. Danach werden mehrere Fenster von Chipgröße auf der Rückseite durch konventionelle Photolithographie und Naßätzen hergestellt. Durch diese Fenster wird später das Ätzen des Wafers vorgenommen. Auf die bordotierte Vorderseite des Wafers wird dann eine etwa 0,4 bis 0,8 µm dicke Siliciumdioxidschicht aufgesputtert. Anschließend wird, für eine Siliciumdioxidschichtdicke unter 0,5 µm, auf die Siliciumdioxidschicht eine Positivphotoresistschicht in einer Schichtdicke von etwa 0,2 bis 0,5 µm aufgetragen. Durch Belichten und Entwickeln wird in dieser Resistschicht das gewünschte Maskenmuster erzeugt. Für Muster mit Dimensionen im Submikrometerbereich wird diese Belichtung mit einem Elektronenstrahlschreiber (Vector Scan) durchgeführt. Die strukturierte Resistschicht dient als Maske zum Ätzen der Siliciumdioxidschicht auf der Vorderseite des Wafers. Die Strukturierung der Siliciumdioxidschicht erfolgt durch reaktives Ionenätzen mit $CF_4$. Nach dem Strippen des restlichen Resists wird die strukturierte Siliciumdioxidschicht in einem zweiten reaktiven Ionenätzprozeß als Maske verwendet, um ein Muster von etwa 2 bis 4 µm Tiefe in das bordotierte Silicium zu ätzen. In diesem Verfahrensschritt wird ein $SF_6$, $Cl_2$ und Helium-Gemisch angewendet. Unter den gewählten Bedingungen werden Ätzratenverhältnisse zwischen Siliciumdioxid und Silicium von 1:5 bis etwa 1:20 erhalten. Durch dieses streng gerichtete Ätzen werden nahezu vertikale Siliciumseitenwände erhalten. Zum Ätzen von Silicium sind auch andere Gasmischungen geeignet.

Schließlich wird das Wafersubstrat durch die Öffnungen in der Siliciumdioxidschicht auf der Rückseite des Wafers in einem Naßätzprozeß gerichtet geätzt. Es wird eine Ätzlösung aus Äthylendiamin, Brenzkatechin, Pyrazin und Wasser verwendet. Das Ätzen hört auf bei einer Borkonzentration von etwa $7 \times 10^{19}$ Boratomen/$cm^3$. Die Maske aus der einkristallinen, bordotierten Membran ist etwa 2 µm dick, in Abhängigkeit von der angewendeten Bordiffusion. Nach dem Entfernen der restlichen Siliciumdioxidschichten wird die strukturierte Siliciummembran mit einer etwa 0,2 bis 0,8 µm dicken Goldschicht belegt. Diese ist erforderlich, um einen Elektronenstrahl bis zu Energien von etwa 25 keV abzubremsen.

Um Strukturen mit einer Auflösung bis zu etwa 1/4 µm herstellen zu können, wird anstelle des zuvor beschriebenen Photoresistprozesses ein Dreilagen-Photoresistprozeß angewendet.

Nach der Herstellung der Maske müssen zunächst alle Muster dieser Maske, d.h. alle Löcher, auf ihre Sollmaße untersucht werden. Bei dieser Untersuchung wird festgestellt, ob sich die Löcher am richtigen Platz befinden und ob ihre Form und Größe mit den Strukturdaten der Maske übereinstimmen. Außerdem wird festgestellt, od unerwünschte Löcher, sogenannte Defektlöcher, innerhalb und außerhalb des eigentlichen Maskenmusters oder Verunreinigungen wie Staubpartikel im Bereich der Löcher vorhanden sind. Die Inspektion der Maske kann in einem Elektronenstrahlschreiber (Vector Scan) oder in einem Elektronenstrahl-Projektionssystem durch einen Vergleich der Daten des vom Elektronenstrahl gefundenen Maskenlochs mit den im Computer bereits vorhandenen Daten der Maskenstruktur erfolgen. Wird auf diese Weise festgestellt, daß beispielsweise ein unerwünschtes Loch in der Maske vorhanden ist, dann muß dieses Loch an der entsprechenden Stelle gezielt repariert werden. In gleicher Weise wird durch Vergleich von Computerdaten festgestellt, ob sich Staubpartikel innerhalb der Maskenlöcher befinden. Nach der Inspektion der Maske wird die Maske aus dem Gerät entnommen und wie bei dem in IBM-TDB, Vol. 27, No. 8, Jan. 1985, S. 4815-4816 beschriebenen Verfahren auf ihrer Vorderseite ganzflächig mit einer Photoresistschicht bedeckt, die alle Löcher der Maske verschließt. Zur Beschichtung können bekannte, positiv oder negativ arbeitende Photoresistmaterialien verwendet werden. Jetzt könnte das von dem Photoresist bedeckte Maskenmuster wieder geöffnet werden, indem man die gesamte Schaltkreisstruktur erneut belichtet. Alle Löcher, die nicht zum Maskenmuster gehören, blieben dann verschlossen. Wenn die Schaltkreisdichte sehr hoch ist, nimmt diese Art der Reparatur eine sehr lange Zeit in Anspruch. Deshalb wird gemäß der Erfindung nicht jede Stelle der Photoresistschicht, unter der sich ein gewünschtes Maskenloch befindet, neu belichtet, sondern es werden nur noch diejenigen Stellen der Photoresistschicht, die sich über Defektlöchern befinden, neu belichtet. Dadurch wird die Zeit für die Reparatur der Maske erheblich verkürzt. Das Belichtungssystem, in das die zu reparierende Maske gegeben wird, fährt mit dem belichtenden Elektronenstrahl genau die Stelle der Maske an, die zu reparieren ist und deren Daten (Ortskoordinaten) bei der vorhergegangenen Inspektion in dem Belichtungssystem gespeichert wurden. Das Belichtungssystem schreibt dann als Ergebnis des Vergleichs dieser Daten mit den Strukturdaten der gewünschten Maskenlöcher über der zu reparierenden Stelle der Maske ein Muster, das der Größe des Defektlochs entspricht. Bei der Elektronenstrahlbelichtung muß die Strahldosis in Abhängigkeit von dem zu belichtenden Photoresist so gewählt werden, daß dieser vernetzt und dadurch unlöslich wird. Bei den derzeit erhältlichen, negativ arbeitenden Photoresistmaterialien liegt diese Dosis in einem Bereich von etwa 50 bis 80 µC/cm². Sie muß positiv arbeitenden Photoresistmaterialien auf die etwa dreifache Dosis von 150 bis 300 µC/cm² erhöht werden, damit der Photoresist über dem Defektloch beim Belichten stark vernetzt und dadurch unlöslich wird. Jetzt folgt, bei Anwendung eines positiv arbeitenden Photoresists, eine ganzflächige Belichtung mit lichtoptischer Strahlung, beispielsweise mit UV-Licht, damit der Photoresist in den Bereichen, die keiner Reparatur bedürfen, in einem konventionellen Entwickler für Positivphotoresistmaterialien weggelöst werden kann. Bei negativ arbeitenden Resistmaterialien, bei denen nicht belichtete Resistbereiche mit einem organischen Lösungsmittel entwickelt, d.h. weggelöst werden, entfällt dieser Belichtungsschritt. Nach dem Verschließen aller Defektlöcher der Transmissionsmaske wird diese von der Rückseite her mit Gold bedampft, wobei die stehengebliebenen, vernetzten Bereiche der Photoresistschicht als Unterlage dienen. Anschließend werden diese Bereiche der Photoresistschicht in einem Sauerstoffplasma entfernt.

Das zuvor beschriebene Verfahren kann nicht nur zum Verschließen von ungewünschten Defektlöchern verwendet werden, sondern auch zur Korrektur fehlerhafter, gewünschter Maskenöffnungen, beispielsweise zur Korrektur ausgefranster Maskenöffnungen. In diesem Fall schreibt das Elektronenstrahl-Belichtungssystem in die Photoresistschicht über dem fehlerhaften Loch ein Muster, in dem das gewünschte Loch ausgespart wird. Die Strahldosis wird, wie oben bereits erläutert, so gewählt, daß der belichtete Photoresist um das gewünschte, aber zu korrigierende Loch herum vernetzt und unlöslich wird. Dann folgen, wie zuvor beschrieben, bei positiv arbeitenden Resistsystemen eine ganzflächige Belichtung und die Entwicklung des Resists. Auf diese Weise ist es möglich, die Form von Maskenlöchern zu korrigieren.

Sind innerhalb gewünschter Maskenlöcher Verunreinigungen, wie Staubpartikel, zu entfernen, wird ebenfalls auf die Vorderseite der Maske ganzflächig eine Photoresistschicht aufgetragen. Durch eine Belichtung mit dem Elektronenstrahl mit normaler Dosis können die Löcher der Maske wieder geöffnet werden. Es können in einem Elektronenstrahl-Belichtungssystem aber auch diejenigen Bereiche der Photoresistschicht belichtet werden, die komplementär zu den über den zu reinigenden Löchern der Maske liegenden Bereichen der Photoresistschicht sind. Durch die Wahl der Strahldosis in Abhängigkeit von dem zu belichtenden Photoresist findet in diesen Bereichen eine Vernetzung des Photoresists statt. Bei Anwendung eines positiv arbeitenden Photoresists erfolgt wiederum eine ganzflächige Belichtung mit UV-Licht, damit die nicht mit dem Elektronenstrahl belichteten Bereiche der Photoresistschicht bei der Entwicklung löslich werden. Bei einem negativ arbeitenden Photoresist entfällt dieser Belichtungsschritt vor der Entwicklung. Aus den nach dem zuvor beschriebenen Verfahren «geöffneten» Löchern können nunmehr unerwünschte Staubpartikel in einem Naß- oder einem Trockenätzverfahren entfernt werden. Die die Maske bedeckende Photoresistschicht wird danch in einem Sauerstoffplasma abgeätzt.

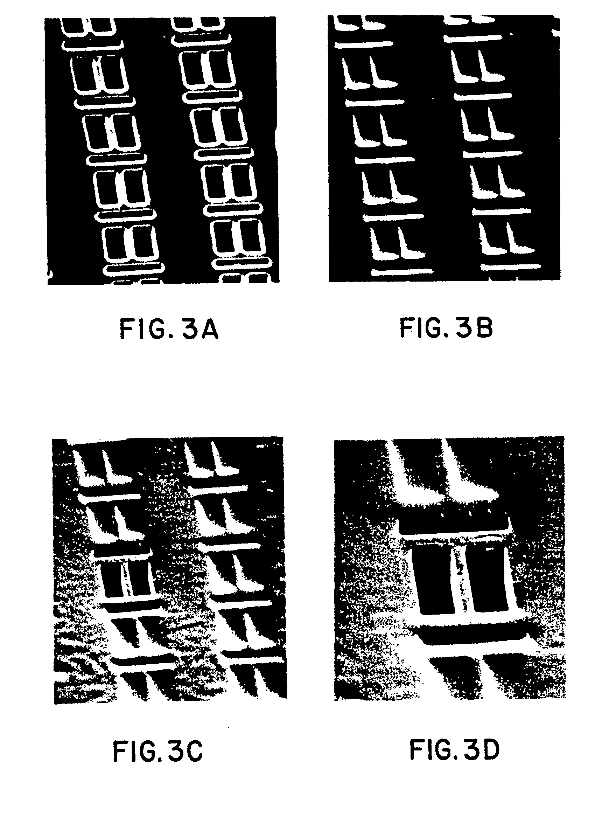

Nachfolgend wird kurz auf die Figuren 2 bis 5 eingegangen. In Fig. 2A ist eine Transmissionsmaske mit geöffneten Löchern dargestellt. In Fig. 2B ist dieselbe Transmissionsmaske dargestellt, bei der jedoch durch Belichten einer Photoresistschicht über der Lochmaske in einem Streifenmuster je zwei Stege aus vernetztem Photoresist über das einzelne Maskenloch gelegt wurden. In Fig. 3A ist eine Transmissionsmaske dargestellt, bei der alle Löcher der Maske geöffnet sind. Fig. 3B zeigt dieselbe Maske, wobei die Oberfläche ganzflächig mit Photoresist bedeckt ist. Fig. 3C zeigt die Maske, in der auf der linken Seite ein Loch, aus dem eine Verunreinigung zu entfernen ist, geöffnet ist. In Fig. 3D ist dieses Loch mit dem zu entfernenden Staubpartikel in Vergrößerung dargestellt.

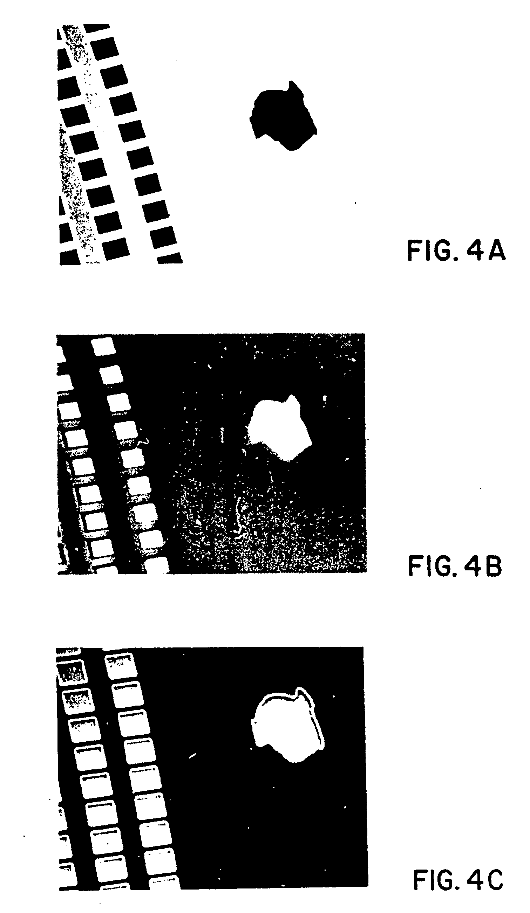

In Fig. 4A ist eine Transmissionsmaske mit einem Defektloch des eigentlichen Maskenmusters dargestellt. Fig. 4B zeigt dieselbe Maske mit ganzflächiger Photoresistbedeckung und Fig. 4C dieselbe Maske nach der Entfernung des Photoresists, jedoch mit selbsttragender Goldschicht im Bereich der Löcher.

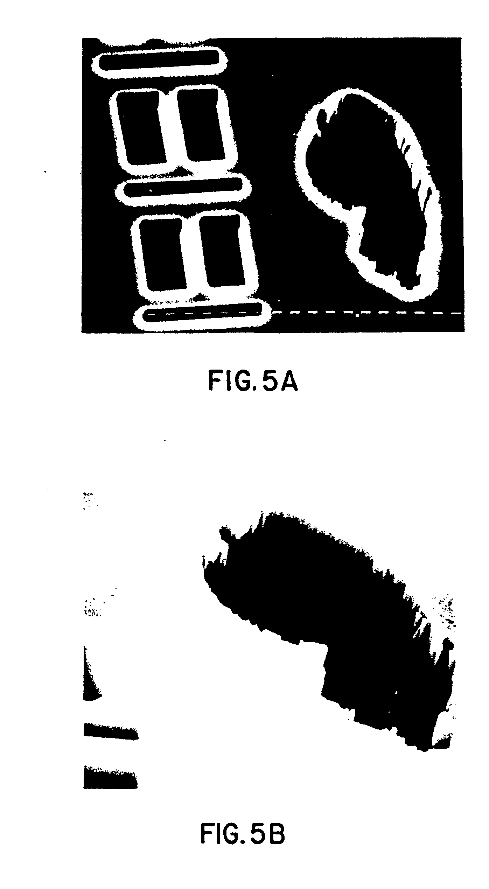

In Fig. 5A ist ein Ausschnitt aus einer weiteren Transmissionsmaske mit einem Defektloch dargestellt, welches nach dem zuvor beschriebenen Verfahren repariert und mit einer Goldschicht verschlossen wurde (Fig. 5B).

In einem speziellen Ausführungsbeispiel wird eine zu reparierende Maske mit einer Photoresistschicht in einer Schichtdicke von etwa 0,5 bis 2 µm bedeckt. Als Photoresistmaterialien kommen Positivphotoresistmaterialien, beispielsweise AZ 1450J oder 1350J der Firma Shipley, welcher aus einem Phenol-Formaldehydharz und 3,4-Dihydroxybenzophenon--4-[naphthochinon-(1,2)diazid(2)]-sulfonat als reaktivem Bestandteil besteht oder ein Resist auf der Basis von Polymethylmethacrylat in Frage. Nach der Belichtung der positiven Resistschicht nach den von dem Schreibsystem gespeicherten Struktur- und Inspektionsdaten der Maske, mit einer hohen Elektronenstrahldosis von etwa 200 µC/cm², wird eine ganzflächige Belichtung durchgeführt. In einem handelsüblichen Entwickler werden dann die einfach belichteten Bereiche der Photoresistschicht entfernt. Nur diejenigen Bereiche der Resistschicht, welche zweimal belichtet wurden und vernetzt sind, bleiben über den zu korrigierenden Bereichen der Transmissionsmaske stehen. Anschließend wird die Maske von ihrer Rückseite her mit Gold bedampft, wobei die stehengebliebene Resistschicht als Substrat dient. Danach wird der restliche Resist in einem Sauerstoffplasma entfernt. Als Ergebnis dieses Verfahrens wird eine Transmissionsmaske erhalten, bei der alle unerwünschten Löcher mit Gold geschlossen und alle fehlerhaften Löcher auf Sollmaß gebracht worden sind.

Alle zuvor beschriebenen Maskenkorrekturverfahren können außer in Elektronenstrahl-Belichtungssystemen auch in solchen mit Ionenstrahlen oder Röntgenstrahlen oder mit Laser- bzw. UV-Strahlung durchgeführt werden. Der Vorteil des beschriebenen Maskenreparaturverfahrens, bei dem die Photoresistschicht über der zu reparierenden Stelle direkt aufgrund eines Vergleichs von Daten von dem Belichtungssystem angefahren wird, ist, daß die Maskenreparatur innerhalb von Millisekunden ausgeführt werden kann.

## Patentansprüche

1. Verfahren zur Reparatur von Transmissionsmasken, bei dem die gespeicherten Daten der Maskenstruktur mit den Ortskoordinaten unerwünschter Maskenlöcher verglichen werden, gekennzeichnet durch folgende Verfahrensschritte:

a) Inspektion der Maske zur Feststellung von Maskenfehlern und Erhalt von Ortskoordinaten derselben durch einen Vergleich der bei der Inspektion der Maske mit einem Elektronenstrahlrastermikroskop oder einem Elektronenstrahlschreiber oder mit einem Elektronenstrahl-Projektionssystem erhaltenen Koordinaten des fehlerhaften Maskenmusters mit den in einem Computer gespeicherten Daten des gewünschten Maskenmusters;

b) Beschichten der Vorderseite der fehlerhaften Maske mit einem Photoresist;

c) Belichten des Photoresists mit Elektronen-, Ionen- oder Röntgenstrahlen, oder Laser- bzw. UV-Strahlung zu seiner Vernetzung in den Bereichen, die durch die Ortskoordinaten der unerwünschten Maskenlöcher definiert sind;

d) Entfernen der nach c) nicht belichteten Bereiche der Photoresistschicht;

e) gegebenenfalls Bedampfen der Maske von der Rückseite her mit Gold und

f) Entfernen der vernetzten Bereiche der Photoresistschicht in einem Trockenätzverfahren.

2. Verfahren nach Anspruch 1, dadurch gekennzeichnet, daß die Vorderseite der Maske (Fign. 3B, 4B) mit einem negativ arbeitenden Photoresist beschichtet wird.

3. Verfahren nach den Ansprüchen 1 und 2, dadurch gekennzeichnet, daß der negativ arbeitende Photoresist mit einer Dosis im Bereich von etwa 50 bis 80 µC/cm² belichtet wird.

4. Verfahren nach Anspruch 1, dadurch gekennzeichnet, daß die Vorderseite der Maske (Fign. 3B, 4B) mit einem positiv arbeitenden Photoresist beschichtet wird:

5. Verfahren nach den Ansprüchen 1 und 3, dadurch gekennzeichnet, daß der positiv arbeitende Photoresist mit einer Dosis im Bereich von etwa 150 bis 300 µC/cm² belichtet wird.

6. Verfahren nach den Ansprüchen 1, 4 und 5, dadurch gekennzeichnet, daß die positive Photoresistschicht nach der bildmäßigen Belichtung (Schritt c) ganzflächig mit lichtoptischer Strahlung belichtet wird.

7. Verfahren nach Anspruch 1, dadurch gekennzeichnet, daß zur Korrektur eines fehlerhaften, gewünschten Maskenlochs mit einem Elektronenstrahl in die Photoresistschicht über diesem Loch ein Muster geschrieben wird, das das gewünschte Maskenloch ausspart.

8. Verfahren nach Anspruch 1, dadurch gekennzeichnet, daß zur Entfernung von Staubpartikeln aus gewünschten Maskenlöchern diejenigen Bereiche der Photoresistschicht mit einem Elektronenstrahl belichtet und vernetzt werden, die komplementär zu den über den zu reinigenden Löchern liegenden Bereichen der Photoresistschicht sind, daß die Photoresistbereiche über den zu reinigenden Löchern in bekannter Weise bei der Entwicklung entfernt werden und anschließend die Staubpartikel aus den geöffneten Maskenlöchern durch ein Naß- oder Trockenätzverfahren entfernt werden (Fign 3B bis 3D).

## Claims

1. Method of repairing transmission masks, wherein the stored data of the mask structure is compared with the position coordinates of undesired mask holes, characterized by the following steps:

a) inspection of the mask for detecting mask defects and for determining their position coordinates by comparing the coordinates of the defective mask pattern, obtained by inspecting the mask with an electron raster microscope or an electron beam scanner or an electron beam projection system, with the data of the desired mask pattern stored in a computer;

b) coating the front side of the defective mask with a photoresist;

c) exposing the photoresist by means of electron or ion beams, X-rays or laser and UV-radiation, respectively, for its cross-linkage in regions defined by the position coordinates of the undesired mask holes;

d) removing the photoresist regions not exposed in step c);

e) vapor-depositing gold on the rear of the mask, if necessary, and

f) removing the cross-linked regions of the photoresist layer in a dry etch step.

2. Method according to claim 1, characterized in that the front side of the mask (Figs. 3B, 4B) is coated with a negative photoresist.

3. Method according to claims 1 and 2, characterized in that the negative photoresist is exposed at a dose ranging from about 50 to 80 $\mu$C/cm$^2$.

4. Method according to claim 1, characterized in that the front side of the mask (Figs. 3B, 4B) is coated with a positive photoresist.

5. Method according to claims 1 and 3, characterized in that the positive photoresist is exposed at a dose ranging from about 150 to 300 $\mu$C/cm$^2$.

6. Method according to claims 1, 4 and 5, characterized in that the positive photoresist, having been exposed imagewise (step c), is blanket exposed by means of photooptical radiation.

7. Method according to claim 1, characterized in that for correcting a defective desired mask hole, a pattern, in which the desired mask hole is not exposed, is written into the photoresist layer overlaying said hole.

8. Method according to claim 1, characterized in that for removing dust particles from desired mask holes, the photoresist regions complementary to those overlying the holes to be cleaned are exposed by means of an electron beam and cross-linked, that the photoresist regions overlying the holes to be cleaned are removed in a known manner during development, and the dust particles are subsequently removed from the opened mask holes by wet or dry etching (Figs. 3B to 3D).

## Revendications

1. Procédé de correction de masques par transmission, dans lequel les données mémorisées de la structure de masque sont comparées avec les coordonnées locales de perforations de masque non souhaitées, caractérisé par les stades opératoires suivants:

a) inspection du masque pour déterminer les défauts du masque et obtenir leurs coordonnées locales, par une comparaison des coordonnées de la configuration de masque défectueuse, obtenues lors de l'inspection du masque avec un microscope à balayage à faisceau électronique ou un enregistrement à faisceau électronique ou bien un système de projection à faisceau électronique, avec les données de la configuration de masque souhaitée mémorisée dans un calculateur;

b) application d'un vernis photorésist sur la face antérieure du masque défectueux;

c) éclairement du photorésist par des faisceaux d'électrons, d'ions ou de rayons X, ou par rayons laser ou UV, pour le réticuler dans les zones qui sont définies par les coordonnées locales des perforations de masque non-souhaitées;

d) élimination des zones de la couche de photorésist non éclairées selon c);

e) éventuellement dépôt d'or par métallisation dans le vide sur le masque par l'arrière, et

f) élimination des zones réticulées de la couche de photorésist par un procédé de corrosion à sec.

2. Procédé selon la revendication 1, caractérisé en ce qu'on recouvre la face antérieure du masque (figures 3B, 4B) d'un photorésist négatif.

3. Procédé selon les revendications 1 et 2, caractérisé en ce qu'on éclaire le photorésist négatif avec une dose comprise dans un domaine d'environ 50 à 80 $\mu$C/cm$^2$.

4. Procédé selon la revendication 1, caractérisé en ce qu'on recouvre la face antérieure du masque (figures 3B, 4B) d'un photorésist positif.

5. Procédé selon les revendications 1 et 3, caractérisé en ce qu'on éclaire le photorésist positif avec une dose comprise dans un domaine d'environ 150 à 300 $\mu$C/cm$^2$.

6. Procédé selon les revendications 1, 4 et 5, caractérisé en ce qu'on éclaire la couche de photorésist positif après l'éclairement selon l'image (stade c) sur toute la surface par un rayonnement optique.

7. Procédé selon la revendication 1, caractérisé en ce que, pour corriger une perforation de masque souhaitée défectueuse, on imprime avec un faisceau électronique dans la couche de photorésist au-dessus de ce trou une configuration qui ménage la perforation de masque souhaitée.

8. Procédé selon la revendication 1, caractérisé en ce que, pour éliminer des particules de poussière des perforations de masque souhaitées, on éclaire et l'on réticule avec un faisceau électronique les zones de la couche de photorésist qui sont complémentaires des zones de la couche de photorésist situées au-dessus des perforations à nettoyer, on élimine les zones de photorésist au-dessus des perforations à nettoyer de façon connue lors du développement et ensuite on élimine les particules de poussière des perforations de masque ouvertes par un procédé de corrosion par voie humide ou sèche (figures 3B à 3D).

SILIZIUM

0,2 μm
BOR - DOTIERTES
Si

0,5 μm GOLD

FIG. 1

FIG. 2 A

FIG. 2 B

FIG. 3A

FIG. 3B

FIG. 3C

FIG. 3D

FIG. 4 A

FIG. 4 B

FIG. 4 C

FIG. 5A

FIG. 5B